# EUROPEAN PATENT SPECIFICATION

(11) **EP 2 441 856 B1**
(45) Date of publication and mention of the grant of the patent: **16.07.2014**
(21) Application number: 11185553.2
(22) Date of filing: 18.10.2011
(51) Int. Cl.: C23C 14/24, C23C 14/04, C23C 14/56

(54) **Thin film deposition apparatus**
Dünnfilmablagerungsvorrichtung
Appareil de dépôt de film mince

(30) Priority: 18.10.2010 KR 20100101470; 08.04.2011 KR 20110032838
(43) Date of publication of application: 18.04.2012
(60) Divisional application: 14171226.5
(73) Proprietor: Samsung Display Co., Ltd., Yongin-City, Gyeonggi-Do, 446-711 (KR)
(72) Inventor: Kim, Mu-Gyeom, 446-711 Gyunggi-Do (KR); Park, Il-Soo, 446-711 Gyunggi-Do (KR)
(74) Representative: Gulde & Partner

(56) References cited:
- GB-A- 1 447 468
- JP-A- 2003 041 361
- US-A- 3 563 202

## Description

Aspects of embodiments of the present invention relate to thin film deposition apparatuses, and more particularly, to thin film deposition apparatuses for performing continuous deposition, and mask units and crucible units that are included in the thin film deposition apparatuses.

### Description of the Related Art

In order to manufacture a thin film such as a thin film transistor (TFT) of, for example, an organic light-emitting display device, a deposition apparatus in which vapor is generated from a deposition source and is deposited to a surface of a target, such as a substrate, is generally used.

In a general thin film deposition apparatus, a target is mounted in a chamber in which a deposition source is charged, and deposition is performed. After the deposition is completed, the deposition target is extracted from the chamber, and then another target is mounted in the chamber. Thus, since deposition needs to be stopped during the loading and unloading of the targets, performance efficiency may be reduced. In addition, when the deposition source of the crucible is completely consumed, the deposition needs to be stopped again in order to replace the crucible with a new crucible, and thus an operating speed is considerably reduced.

Thus, a need exists for a thin film deposition apparatus which overcomes these disadvantages.

JP 2003 041361 A discloses a deposition apparatus with a rotating cylindrical mask member. The movements of the mask and the substrate are synchronized. A plurality of heated crucibles is provided inside the cylindrical mask to supply coating material through the mask to be deposited on the substrate.

US 3 563 202 A discloses a vapor deposition apparatus comprising a plurality of crucibles installed on a moving circulation path. The crucibles are moved between a crucible filling unit and a crucible heating unit where evaporation takes place.

### SUMMARY

According to the present invention, a thin film deposition apparatus according to claim 1 including mask units and crucible units is provided.

According to an embodiment of the present invention, a thin film deposition apparatus may include: a moving unit configured to move a substrate as a deposition target; a mask unit configured to selectively pass vapor of a deposition source toward the substrate; and a crucible unit including a plurality of crucibles accommodating the deposition source and proceeding along a circulation path passing through the mask unit.

The mask unit may have a continuous perimeter shape.

The moving unit may include: a clamper configured to support the substrate and move together with the mask unit; and a guide rail for supporting the clamper to slide along the guide rail.

The mask unit may include: a mask member including a body in which a mask pattern is formed, wherein at least a portion of the body is configured to be closely disposed to the substrate; a driver for moving the mask member; and a power transfer member configured to transfer power of the driver to the mask member.

The body of the mask member may be a cylindrical member having a cavity.

The power transfer member may include a ring-shaped member having a cavity, the mask member may be inserted in the cavity adjacent an inner wall of the ring-shaped member, and a gear unit for transferring power of the driver may be arranged on an external wall of the ring-shaped member.

The body of the mask member may include a plurality of plate members, the power transfer member may include a plurality of ring-shaped members and a plurality of support pieces on lateral walls of the ring-shaped members, the plurality of plate members may be connected to one another and are supported by the plurality of support pieces, and a gear unit for transferring power of the driver may be arranged on an external wall of the ring-shaped member.

The driver may include: a cradle wheel that is gear-combined with the power transfer member; and a motor connected to the cradle wheel for rotating the cradle wheel. The mask member may be elastically contacted to the substrate so as to increase a contact area with the substrate.

The crucible unit may include: a circulation rail forming the circulation path; a plurality of crucibles for accommodating the deposition source and installed on the circulation rail; a crucible moving unit configured to move the plurality of crucibles along the circulation rail; a crucible filling unit for filling the deposition source in the plurality of crucibles; and a crucible heating unit configured to heat the plurality of crucibles for generating the vapor of the deposition source.

The crucible unit may further include a plurality of ball bearings for supporting the plurality of crucibles on the circulation rail.

The crucible unit may further include a spring on the circulation rail and configured to push the plurality of crucibles toward a wall of the circulation rail.

The crucible moving unit may include a rotatable moving wheel configured to push the plurality of crucibles in a direction of the circulation path.

The crucible filling unit may include: an injection tank in which the deposition source is charged; and an injection nozzle for supplying the deposition source charged in the injection tank to the plurality of crucibles on the circulation rail.

The crucible heating unit may include: a heat wire embedded in the plurality of crucibles; a power source for applying a voltage to the heat wire; and a contact pad on the plurality of crucibles for connecting the power source and the heat wire to each other.

The crucible unit may further include a ball bearing between the contact pad and the power source.

A plurality of contact pads may be respectively disposed in the plurality of crucibles, and a plurality of power sources corresponding to the plurality of contact pads may be respectively disposed so as to selectively apply the voltage.

The thin film deposition apparatus may further include a shield member for guiding the vapor of the deposition source to a deposition location of the substrate.

The shield member may be installed at an upper portion of the crucible unit within the mask unit.

The shield member may be fixed to the mask unit and rotates together with the mask unit.

The mask unit may include a plurality of mask units, the crucible unit may include a plurality of crucible units, and the plurality of mask units and the plurality of crucible units may correspond to the single substrate moving unit.

The mask units and the crucible units may be provided for depositing respective colors of the deposition source.

The thin film deposition apparatus may further include a mask washing unit for removing a residue of the deposition source attached to the mask unit.

The mask washing unit may include: a supersonic wave generator for applying vibration to the mask unit; and a receptacle for receiving the deposition source that detaches from the mask unit due to the vibration.

### BRIEF DESCRIPTION OF THE DRAWINGS

The above and other features and advantages of the present invention will become more apparent by describing in detail some exemplary embodiments thereof with reference to the attached drawings in which:
FIG. 1 is a schematic diagram showing a deposition operation utilizing a thin film deposition apparatus according to an embodiment of the present invention;
FIG. 2 is a perspective view of a thin film deposition apparatus according to another embodiment of the present invention;
FIG. 3 is an exploded perspective view of a mask unit of the thin film deposition apparatus of FIG. 2;
FIG. 4 is a plan view of a crucible unit of the thin film deposition apparatus of FIG. 2;
FIG. 5A is a cross-sectional view of the crucible unit of FIG. 4 taken along the line A-A;
FIG. 5B is a side view of a crucible of the crucible unit of FIG. 5A;
FIG. 6A is a cross-sectional view of the crucible unit of FIG. 4 taken along the line A-A, ;
FIG. 6B is a side view of a crucible of the crucible unit of FIG. 6A;
FIG. 7 is a cross-sectional view of the crucible unit of FIG. 4 taken along the line A-A;
FIG. 8 is a schematic diagram showing a deposition operation utilizing the thin film deposition apparatus of FIG. 2;
FIG. 9 is a schematic diagram showing a deposition operation utilizing a thin film deposition apparatus;
FIG. 10A is an exploded perspective view of a mask unit;
FIG. 10B is a cross-sectional view of the mask unit of FIG. 10A taken along the line B-B;
FIG. 11 is a schematic diagram showing a deposition method utilizing a thin film deposition apparatus including the mask unit of FIGS. 10A and 10B;
FIG. 12A is an exploded perspective view of a mask unit ;
FIG. 12B is a cross-sectional view of the mask unit of FIG. 12A taken along the line C-C; and
FIGS. 13 and 14 are schematic diagrams showing a deposition method utilizing a thin film deposition apparatus including the mask unit of FIGS. 12A and 12B.

### DETAILED DESCRIPTION

Some exemplary embodiments of the present invention will be described more fully hereinafter with reference to the accompanying drawings.

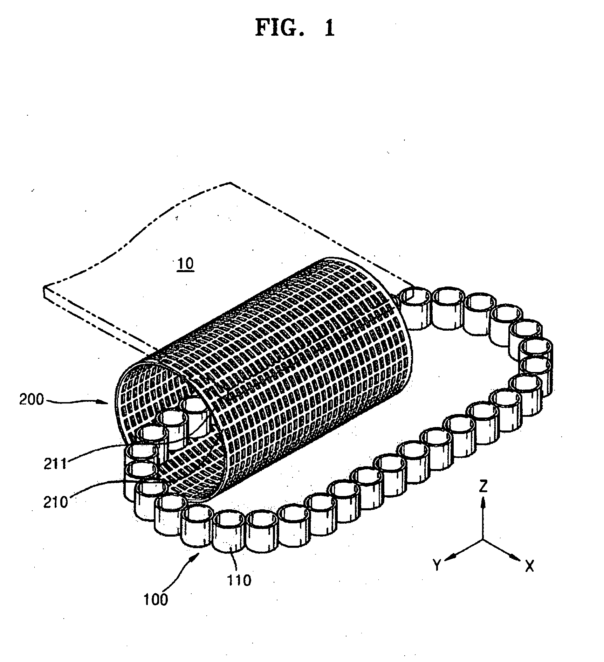

FIG. 1 is a schematic diagram showing a deposition operation utilizing a thin film deposition apparatus according to an embodiment of the present invention.

The thin film deposition apparatus includes a mask unit 200 and a crucible unit 100, which are disposed below a substrate 10 that moves horizontally.

The mask unit 200 is disposed below the substrate 10, and includes a mask member 210 configured in the form of a panel (e.g., a cylindrically-shaped panel), and a mask pattern 211 made up of a plurality of openings that are formed through the mask member 210. The mask member 210 has a caterpillar shape, or a continuous perimeter shape, so that the mask pattern 211 moves in contact with the substrate 10. In detail, the mask member 210 may have a drum shape having a cavity formed in a Y-axis direction.

The crucible unit 100 includes a plurality of crucibles 110. The crucibles 110 may be arranged to circulate in the form of a closed loop. A circulation path of the crucibles 110 passes through the mask unit 200, that is, the cavity of the mask member 210 having a drum shape. In this case, deposition is performed by the crucibles 110 on the mask pattern 211 formed in the mask member 210.

The substrate 10 moves on a horizontal plane above the mask unit 200 in an X-axis direction. In this case, the mask member 210 rotates while contacting the substrate 10 at the same speed as a moving speed of the substrate 10. In addition, the crucibles 110 accommodating materials to be deposited performs the deposition on the substrate 10 through the plurality of openings of the mask pattern 211 while moving in the Y-axis direction.

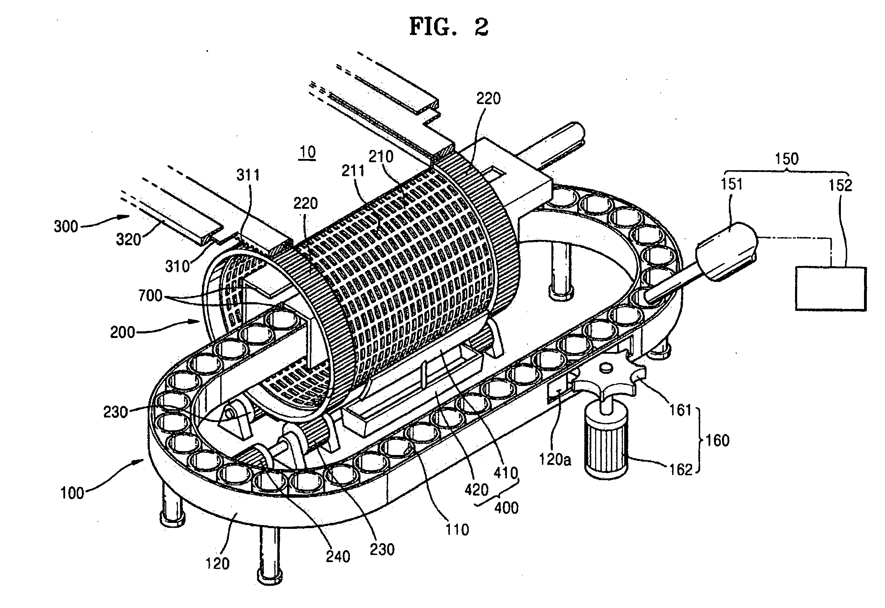

The thin film deposition apparatus according to the present invention may be further embodied as a thin film deposition apparatus of FIG. 2.

FIG. 2 is a perspective view of a thin film deposition apparatus according to the present invention. Referring to FIG. 2, the thin film deposition apparatus includes a substrate moving unit 300 for moving a substrate 10, as a deposition target, to a deposition location, a mask unit 200 for providing a mask pattern 211 corresponding to a pattern to be deposited, and a crucible unit 100 for continuously providing a deposition source. Thus, when the substrate moving unit 300 supports the substrate 10, and moves the substrate 10 to the deposition location, the crucible unit 100 generates vapor from the deposition source, and the vapor of the deposition source is deposited on the substrate 10 through the mask pattern 211 of the mask unit 200. By using the thin film deposition apparatus, continuous deposition may be performed on a plurality of substrates 10.

The substrate moving unit 300 is described below in further detail.

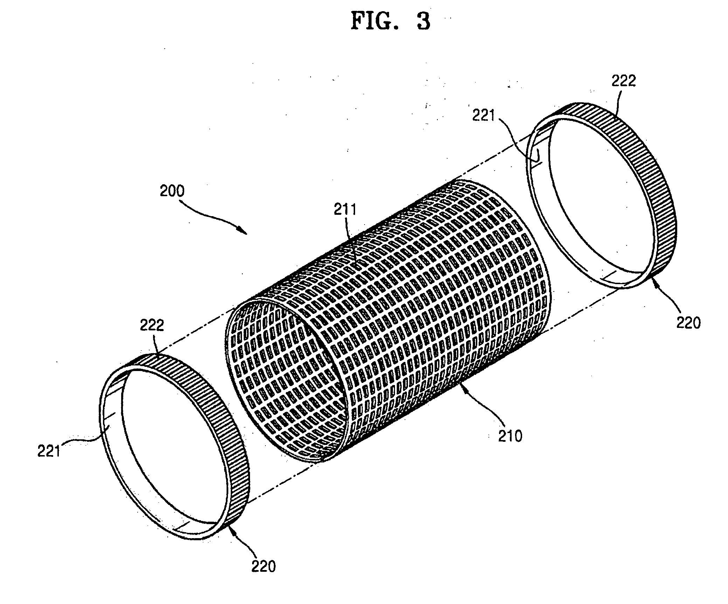

The substrate moving unit 300 includes clampers 310 for clamping and supporting the substrate 10, and guide rails 320 for respectively supporting the clampers 310 so as to slide. That is, the clampers 310 clamping the substrate 10 pass by a deposition position while moving along the guide rails 320. The clampers 310 move in conjunction with the movement of the mask unit 200, which is described below. A gear surface 311 formed on a bottom surface of each clamper 310 is coupled to a gear unit 222 (see FIG. 3) formed on each power transfer member 220 of the mask unit 200, and when the power transfer members 220 of the mask unit 200 rotate, the clampers 310 move along the guide rails 320 in conjunction with the rotation of the power transfer members 220. Thus, when the plurality of substrates 10 are continuously provided and supported by the clampers 310, continuous deposition may be performed on the plurality of substrates 10. Since there is a limit to lengths of the clampers 310 and the guide rails 320, continuous deposition may not be indefinitely performed. However, since continuous deposition may be performed on the plurality of substrates 10 for an extended period, processability is remarkably improved compared to a general method in which loading and unloading are required for each respective substrate.

A structure of the mask unit 200 is described below with reference to FIGS. 2 and 3. The mask unit 200 may continuously provide the mask pattern 211 while moving in conjunction with the substrate 10 that is moving, and thus the mask unit 200 may have a continuous perimeter shape (e.g., like a caterpillar track).

The mask unit 200 includes a cylindrical mask member 210 in which the mask pattern 211 is formed, power transfer members 220 that are each shaped like a ring and in which ends of the mask member 210 are respectively inserted, and one or more cradle wheels 230 and a motor 240 (see FIG. 2) that are drivers for rotating the mask member 210.

As illustrated in FIG. 3 ends of the mask member 210 are inserted into a cavity adjacent to inner walls 221 of the respective power transfer members 220, and the gear units 222 for transferring power are formed on external walls of the power transfer members 220. An upper portion of the gear unit 222 engages with the clamper 310 of the substrate moving unit 300, and a lower portion of the gear unit 222 engages with one or more of the cradle wheels 230. Thus, when the motor 240 rotates the cradle wheel 230, the power transfer member 220 and the mask member 210 that are connected to the cradle wheel 230 rotate together with the cradle wheel 230, and simultaneously the clamper 310 connected to the power transfer member 220 may also move along the guide rail 320. In other words, when the mask member 210 and the substrate 10 move in conjunction with each other, the mask pattern 211 of the mask member 210 may be continuously and accurately provided to the substrate 10 to be moved. The mask member 210 and the substrate 10 may be closely disposed at the deposition location where the mask member 210 and the substrate 10 contact each other. If the mask member 210 and the substrate 10 are not closely disposed at the deposition location, deposition may not be accurately performed on the deposition position of the substrate 10. Therefore, the mask member 210 and the substrate 10 are closely disposed at the deposition location. The crucible unit 100, is described below with reference to FIGS. 2, 4, 5A and 5B. The crucible unit 100 includes a circulation rail 120 forming a circulation path that passes through a hollow of the mask unit 200, a plurality of crucibles 110 mounted on the circulation rail 120, a crucible moving unit 160 for moving the crucibles 110 along the circulation rail 120, a crucible filling unit 150 for filling the deposition source into the crucibles 110, and a crucible heating unit 130 for heating the crucibles 110 so as to generate vapor of the deposition source.

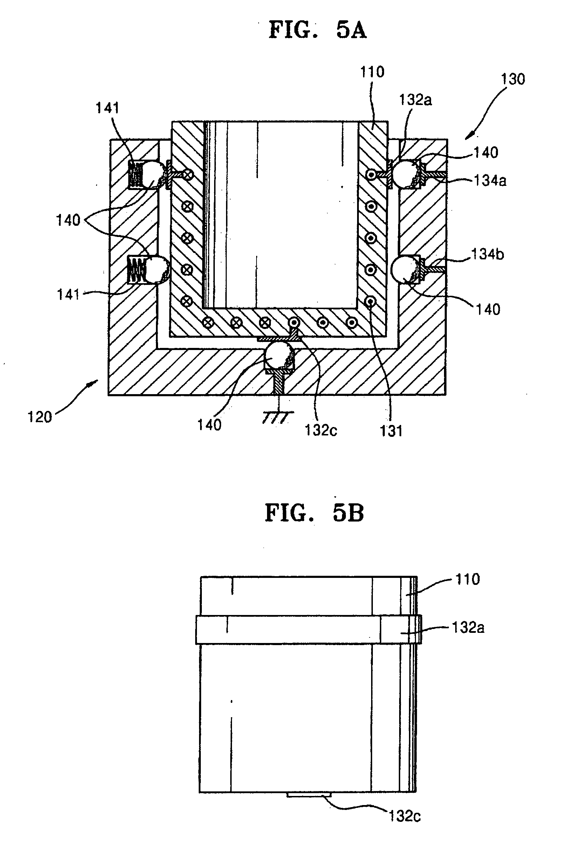

The circulation rail 120 is arranged so as to pass through a hollow of the mask member 210 and the power transfer member 220 of the mask unit 200. Thus, the crucibles 110 mounted on the circulation rail 120 pass through the hollow. When the crucibles 110 pass through the hollow, that is, at a side below the substrate 10, the vapor of the deposition source is generated so as to be deposited on the substrate 10. A plurality of ball bearings 140 (see FIG. 5A) are installed in the circulation rail 120 so as to support the crucibles 110 and provide smooth movement of the crucibles 110 along the circulation rail 120.

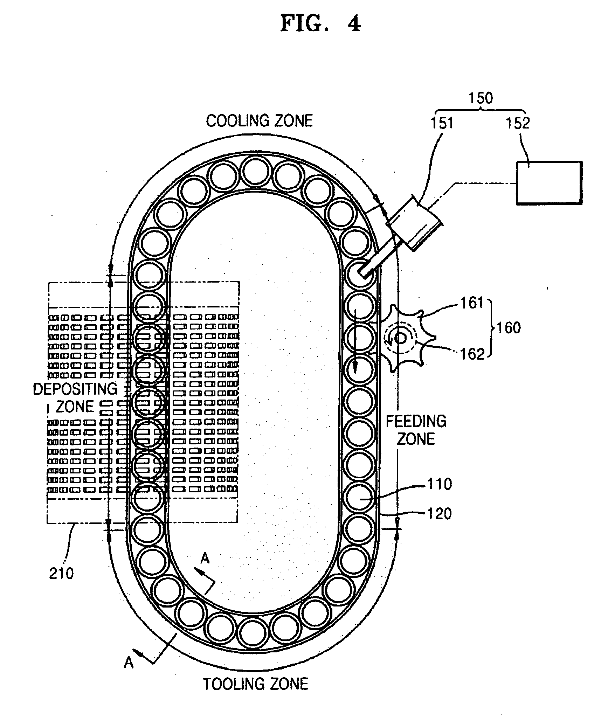

As illustrated in FIG. 4, regions of the circulation path of the circulation rail 120 may be classified as a feeding zone, a tooling zone, a depositing zone, and a cooling zone.

The feeding zone is a zone in which the deposition source is filled in the crucibles 110 by the crucible filling unit 150. The tooling zone is a zone in which the crucibles 110 are heated in order to warm up the deposition source. The depositing zone is a zone in which the circulation rail 120 passes through the hollow of the mask member 210 of the mask unit 200, and in which deposition is performed. The cooling zone is a zone in which the crucibles 110 are cooled down after the deposition is performed. The crucibles 110 proceed continuously along the circulation path of the circulation rail 120. That is, in one embodiment, while the deposition source is fed to one or more first crucibles, the heating is performed on one or more second crucibles, deposition is performed by using one or more third crucibles, and one or more fourth crucibles are cooled. As such, processes of the four zones are concurrently (e.g., simultaneously and continuously) performed while the crucibles 110 move.

The crucible moving unit 160 moves the crucibles 110 along the circulation rail 120 and includes a moving wheel 161 that is rotated by a motor 162. The moving wheel 161 contacts bodies of the crucibles 110 through an opening 120a (see FIG. 2) formed in the circulation rail 120. When the moving wheel 161 rotates, the moving wheel 161 pushes the crucibles 110 in a direction, that is, a circulation direction of the circulation rail 120. Then, the crucible 110 pushed by the moving wheel 161 pushes an adjacent crucible 110 so that the crucibles 110 may simultaneously move in the circulation direction on the circulation rail 120. As described above, in one embodiment, since the ball bearings 140 are installed in the circulation rail 120, the crucibles 110 are moved smoothly along the circulation rail 120.

The crucible filling unit 150 fills the deposition source in the crucibles 110 and includes an injection tank 152 in which the deposition source is charged, and an injection nozzle 151 for supplying the deposition source charged in the injection tank 152. Thus, when the crucible 110 of which deposition source is consumed in the depositing zone enters the feeding zone, the injection nozzle 151 is used to replenish the crucible 110 with the deposition source charged in the injection tank 152.

As illustrated in FIGS. 5A and 5B, the crucible heating unit 130 includes heat wires 131 embedded in the crucibles 110, power supply pads 134a and 134b connected to an external power source (not shown), and a first contact pad 132a that is formed in the crucibles 110 in order to connect the power supply pads 134a and 134b to the heat wires 131. The power supply pads 134a and 134b are formed on the circulation rail 120, and include the first power supply pad 134a and the second power supply pad 134b, to which different voltages are applied. As illustrated in FIGS. 5A and 5B, the first contact pad 132a is formed on external surfaces of the crucible 110. The first contact pad 132a is formed so as to correspond to the first power supply pad 134a, and thus the first contact pad 132a receives power from the first power supply pad 134a, and the second power supply pad 134b does not provide voltages to the crucibles 110. Thus, when a voltage applied by the first power supply pad 134a is supplied to the heat wires 131 through the ball bearings 140 and the first contact pad 132a, the heat wires 131 generate resistance heat so as to heat the crucibles 110. A contact pad 132c grounds a heat wire 131 so as to form a reference voltage with respect to a voltage applied by the power supply pads 134a and 134b.

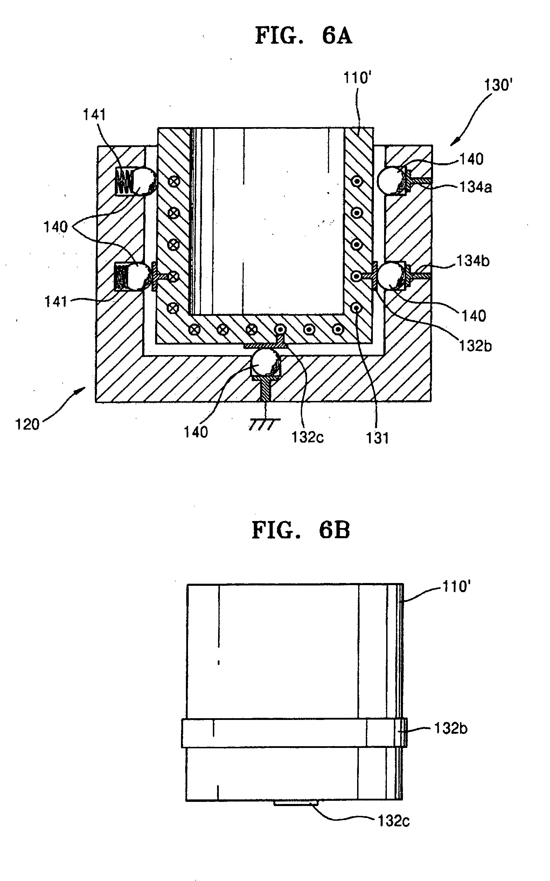

Such a power connection structure for heating the crucibles 110 is installed from the tooling zone to the depositing zone on the circulation rail 120. The power supply pads 134a and 134b, and the contact pad 132a and a second contact pad 132b (see FIGS. 6A and 6B) are electrically connected by interposing the ball bearings 140 installed on the circulation rail 120 therebetween. When the crucibles 110 are positioned at a predetermined point of the circulation rail 120, the ball bearings 140 may be closely installed so that the ball bearings 140 may contact the contact pads 132a and 132b. Thus, power is not disconnected while the crucibles 110 move. One or more springs 141 push the crucibles 110 toward one wall of the circulation rail 120. As such, the crucibles 110 may move while being strongly supported in the circulation rail 120 due to an elastic force of the springs 141.

FIGS. 6A and 6B are a cross-sectional view of a crucible heating unit 130', and a side view of a crucible 110' of the crucible heating unit 130', respectively. The crucible 110' includes the second contact pad 132b formed so as to correspond to the second power supply pad 134b. Thus, the heat wires 131 embedded in the crucible 110' receive a voltage from the second power supply pad 134b.

When the crucibles 110 of FIGS. 5A and 5B and the crucibles 110' of FIGS. 6A and 6B are alternately arranged, and different sources are contained in the crucibles 110 and the crucibles 110', the different sources may be continuously deposited on the substrate 10. For example, a host and a dopant are alternately deposited on the substrate 10 by alternately filling the host and the dopant into the crucibles 110 and circulating the crucibles 110. The host and the dopant may have different temperatures for generating vapor, and smooth deposition may not be performed at the same voltage. Thus, the host is filled into the crucibles 110 of FIGS. 5A and 5B so that the first power supply pad 134a is connected to the first contact pad 132a, and the dopant is filled into the crucible 110' of FIGS. 6A and 6B so that the second power supply pad 134b is connected to the second contact pad 132b. Thus, smooth deposition may be performed with different types of deposition sources due to the crucibles 110 and the crucibles 110' receiving different voltages for heating the host and the dopant to different temperatures.

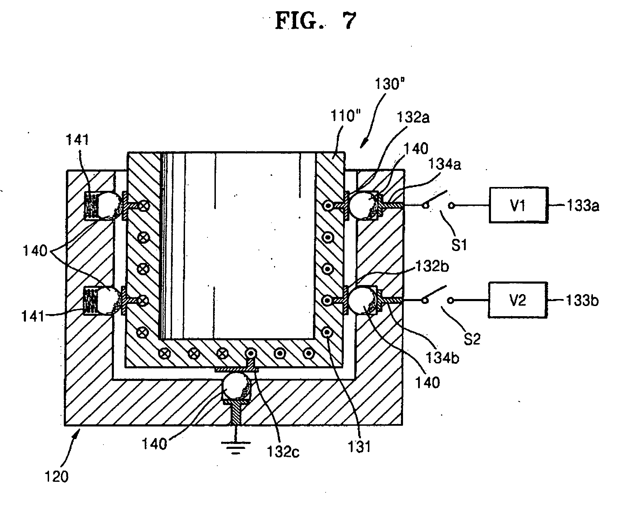

FIG. 7 is a cross-sectional view of a crucible heating unit 130". The crucible 110" includes both the first contact pad 132a and the second contact pad 132b. A first switch S1 is disposed between a first power source 133a and the first power supply pad 134a, and a second switch S2 is disposed between a second power 133b and the second power supply pad 134b so as to selectively apply a voltage to the crucible 110". That is, in one embodiment, when the first power source 133a applies a voltage to the first contact pad 132a, the second power source 133b and the second power supply pad 134b are disconnected from each other. On the other hand, when the second power source 133b applies a voltage to the second contact pad 132b, the first power source 133a and the first power supply pad 134a are disconnected from each other.

The thin film deposition apparatus of FIG. 2 includes a mask washing unit 400 for removing a residue of the deposition source attached to the mask member 210. The mask washing unit 400 includes a supersonic wave generator 410 for applying vibration to the mask member 210, and a bucket 420, or receptacle, for receiving the residue of the deposition source that detaches from the mask member 210 due to the vibration.

The thin film deposition apparatus of FIG. 2 includes one or more shield members 700 installed at upper sides of the crucibles 110 in the hollow of the mask member 210 where deposition is performed. The shield members 700 are configured to guide the vapor of the deposition source to the deposition location of the substrate 10. An operation of the thin film deposition apparatus described above is described below with reference to FIGS. 2 through 8.

When deposition is started, the crucibles 110 of the crucible unit 100 circulate along the circulation rail 120, and the mask member 210 of the mask unit 200 and the substrate 10 may also start being driven. The crucible 110, in which the deposition source is filled by the injection nozzle 151, starts to be slowly heated from a point of time when passing through the tooling zone of the circulation rail 120. Then, the crucible 110 starts generating vapor while entering the depositing zone and passes through the hollow of the mask member 210. The vapor of the deposition source is deposited on the substrate 10 through the mask pattern 211 of the mask member 210. These operations are continuously performed while the substrate 10, the mask member 210, and the crucibles 110 move. As the deposition is performed, the residue of the deposition source attached to the mask member 210 is detached from the mask member 210 by the supersonic wave generator 410 of the mask washing unit 400 and is received in the bucket 420. Thus, according to the above-described embodiment of the present invention, an operation speed is significantly increased, and the deposition is performed while the mask member 210 and the substrate 10 are closely disposed, thereby stably maintaining high deposition quality.

Some additional embodiments of a thin film deposition apparatus according to the present invention are described below and may include one or more components which are modified from the corresponding components of the thin film deposition apparatus described above and shown in FIGS. 2 through 8.

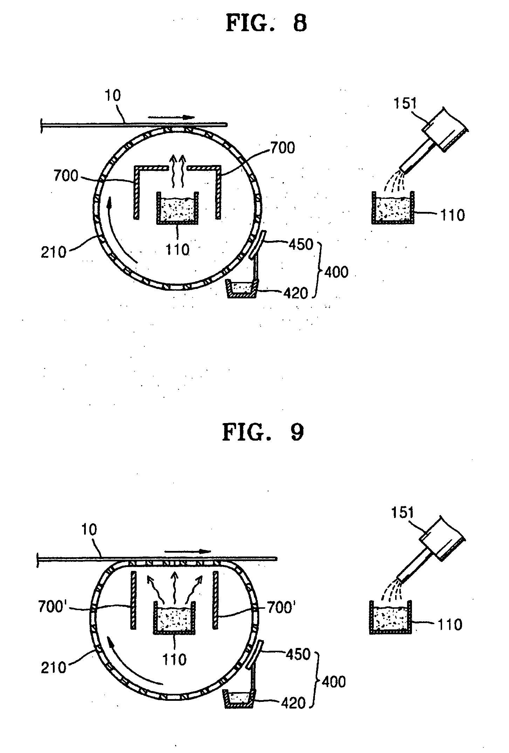

Referring to FIG. 9, the mask member 210 may be further closely disposed to the substrate 10 by increasing an adhesion force between the mask member 210 and the substrate 10. Thus, a contact area between the mask member 210 and the substrate 10 is increased, and a wide area for deposition may be utilized. Further, a shield member 700' for guiding the vapor of the deposition source may have a wider opening than the shield member 700 in the above-described embodiment.

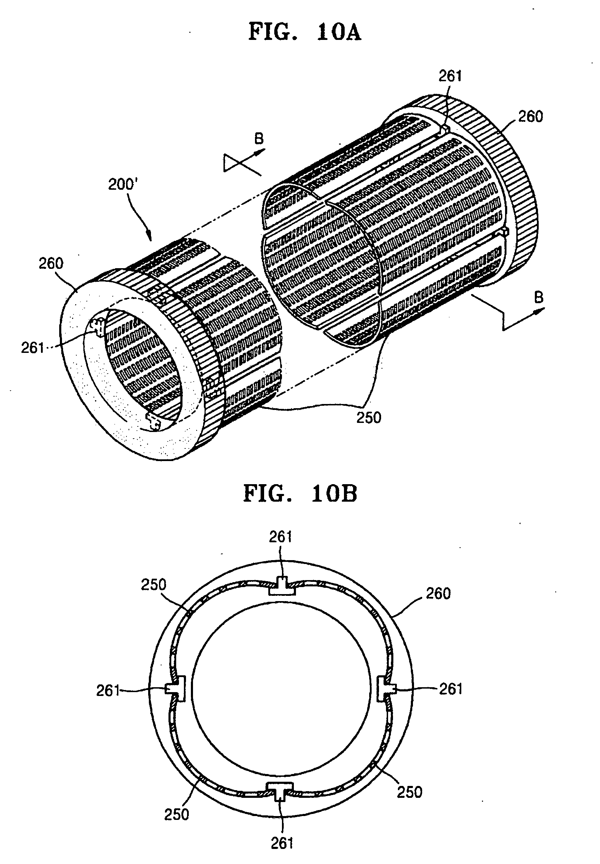

FIGS. 10A and 10B show a mask unit 200' according to another embodiment of the present invention. While in the mask unit 200 according to the above-described embodiment, the mask member 210 is cylindrical, according to another embodiment, the mask unit 200' includes a plurality of plate members 250 connected to each other so as to have a continuous perimeter shape (e.g., a caterpillar shape). When the plate members 250 are connected to each other so as to have a caterpillar shape, drooping or deformation of the mask member may be prevented or reduced. In one embodiment, a plurality of support pieces 261 are formed at an inner wall of a power transfer member 260, and the plate members 250 are connected to each other so as to have a caterpillar shape while being elastically supported by the support pieces 261, as illustrated in FIG. 10B.

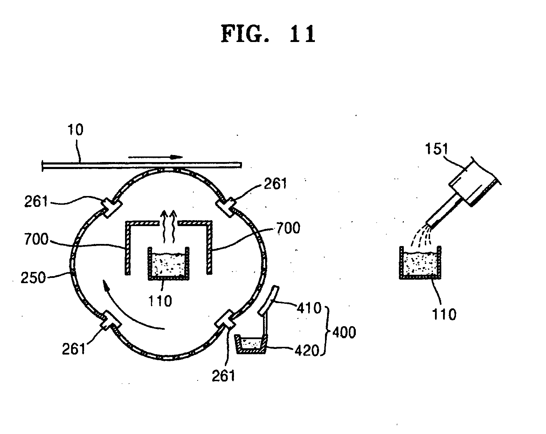

A deposition operation using the mask unit 200' according to the above-described embodiment may be performed as illustrated in FIG. 11. In one embodiment, filling, circulation, and heating of the crucibles 110 of the crucible unit 100, and driving the mask member including the plate members 250, and the substrate 10, are performed as in the above-described embodiment of FIGS. 2 through 8. That is, although a shape of the mask member of the mask unit 200' is different from the above-described embodiment of FIGS. 2 through 8, the deposition operation may be the same or substantially the same as the above-described embodiment. However, in the mask unit 200', since the plate members 250 are connected to each other to form the mask member, the mask member does not have a completely cylindrical shape, and thus a contact area with the substrate 10 is reduced. That is, the plate members 250 and the substrate 10 do not contact each other where the support pieces 261 are arranged between the plate members 250. Therefore, in one embodiment, a plurality of mask units 200 and a plurality of crucible units 100 are disposed so as to compensate for the reduced contact area, which will be described with reference to the following embodiment.

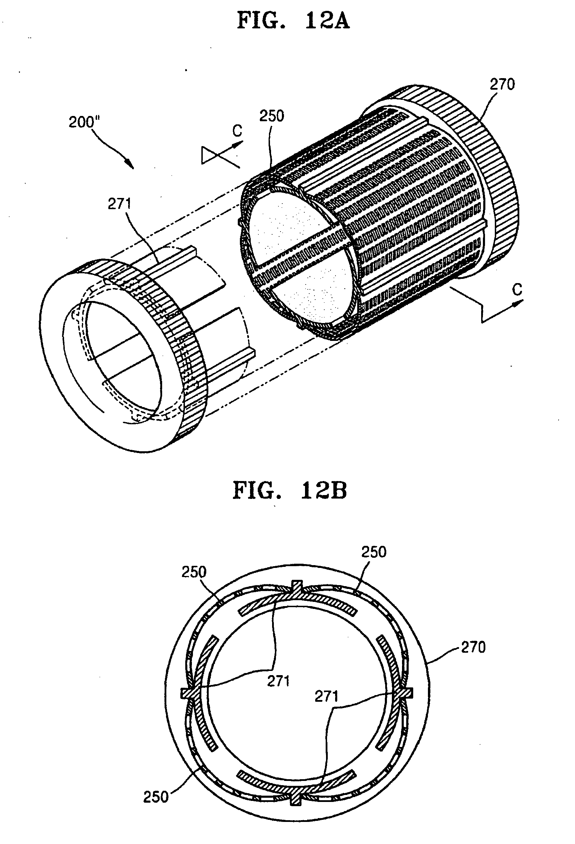

FIGS. 12A and 12B show a mask unit 200". Referring to FIGS. 12A and 12B, instead of using the shield member 700 of FIG. 2, a plurality of shield members 271 that also function as support pieces of the plate members 250 are fixedly installed on the mask unit 200". The shield members 271 may elastically support the plate members 250 forming the mask member, and simultaneously may be disposed between two power transfer members 270 so as to guide the vapor of the deposition source through gaps of the shield members 271.

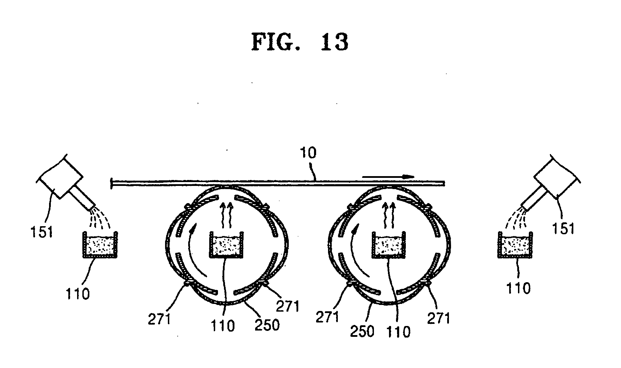

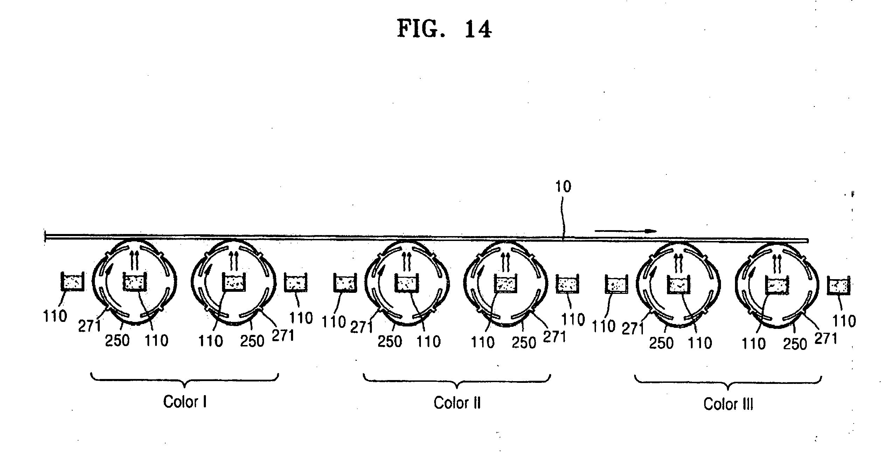

FIG. 13 shows an operation of a thin film deposition apparatus including the shield members 271. That is, the mask member connected by the plate members 250 is closely disposed to the substrate 10, and moves. In one embodiment, the vapor of the deposition source filled in the crucibles 110 is guided into the gaps between the shield members 271 so as to be deposited on the substrate 10. Since the vapor is deposited only through the gaps between the shield members 271, a plurality of mask units 200" and a plurality of crucible units 100 are installed so as to compensate for a reduced depositing area, as illustrated in FIG. 13. Similarly, in the embodiment illustrated in FIG. 11, a plurality of mask units 200' and a plurality of crucible units 100 may be installed so as to compensate for the reduced depositing area of the mask unit 200'. With reference to FIG. 14, sets of the mask unit 200" and the crucible unit 100 are installed for respective colors. That is, in order to deposit various colors, the sets of the mask unit 200" and the crucible unit 100 are installed for the respective colors so as to perform continuous deposition. Various sets of the mask unit 200" and the crucible unit 100 may be installed for each respective color. A similar operation for depositing various colors may be performed utilizing sets of the mask units 200 or 200' according to the embodiments described above.

As described above, in the thin film deposition apparatus according to embodiments of the present invention, supplying and consuming of a deposition source, arranging of a mask and a substrate, and removing of a residue of the deposition source from the mask may be continuously performed, significantly increasing an operating speed. Further, deposition is performed while the substrate and the mask are closely disposed to each other, thereby maintaining good deposition quality.

Since a substrate and a mask unit are closely disposed to each other only at a point when deposition is performed, fine patterns may be formed without a shadow effect, and color mixture does not occur when deposition is performed in order to form emissive layers of an organic light-emitting display device.

A problem that deposition is not performed on a large-sized substrate due to drooping of a planar mask is overcome, and deposition is easily performed on the large-sized substrate.

Since deposition sources are gradually filled into respective crucibles, a time taken to stop an operation a thin film deposition apparatus in order to clean a chamber or to fill deposition sources may be reduced, and thus productivity of deposition may be increased, and deposition sources may not be wasted.

## Claims

1. A thin film deposition apparatus comprising:
a moving unit (300) configured to move a substrate (10) as a deposition target;
a mask unit (200) configured to selectively pass vapor of a deposition source toward the substrate (10), the mask unit (200) comprising a mask member (210) comprising a body in which a mask pattern (211) is formed, a driver for moving the mask member (210), and
a power transfer member (220) configured to transfer power of the driver to the mask member (210); and
a crucible unit (100) comprising a circulation rail (120) forming a circulation path passing through the mask unit (200), a plurality of crucibles (110) for accommodating the deposition source and installed on the circulation rail (120), a crucible moving unit (160) configured to move the plurality of crucibles (110) along the circulation rail (120), a crucible filling unit (150) for filling the deposition source in the plurality of crucibles (110), and a crucible heating unit (130) configured to heat the plurality of crucibles (110) for generating vapor of the deposition source.

2. The thin film deposition apparatus of claim 1, wherein the moving unit (300) comprises:
a clamper (310) configured to support the substrate (10) and move together with the mask unit (200); and
a guide rail (320) for supporting the clamper (310) to slide along the guide rail (320).

3. The thin film deposition apparatus of claim 1 or 2, further comprising a shield member (700) for guiding the vapor of the deposition source to a deposition location of the substrate (10).

4. The thin film deposition apparatus of any of the preceding claims, further comprising a mask washing unit (400) for removing a residue of the deposition source attached to the mask unit (200).

5. The thin film deposition apparatus of claim 1, wherein the body of the mask member (210) is cylindrical.

6. The thin film deposition apparatus of claim 5,
wherein the power transfer member (220) comprises a ring-shaped member having a cavity,
wherein the mask member (210) is inserted in the cavity adjacent an inner wall (221) of the ring-shaped member, and
wherein a gear unit (222) for transferring power of the driver is arranged on an external wall of the ring-shaped member.

7. The thin film deposition apparatus of claim 1, further comprising a plurality of ball bearings (140) for supporting the plurality of crucibles on the circulation rail (120).

8. The thin film deposition apparatus of claim 1, further comprising a spring (141) on the circulation rail (120) and configured to push the plurality of crucibles (110) toward a wall of the circulation rail (120).

9. The thin film deposition apparatus of claim 1, wherein the crucible moving unit (100) comprises a rotatable moving wheel (161) configured to push the plurality of crucibles (110) in a direction of the circulation path.

10. The thin film deposition apparatus of claim 1, wherein the crucible filling unit (150) comprises:
an injection tank in which the deposition source is charged; and
an injection nozzle for supplying the deposition source charged in the injection tank to the plurality of crucibles on the circulation rail.

11. The thin film deposition apparatus of claim 1, wherein the crucible heating unit (130) comprises:
a heat wire (131) embedded in the plurality of crucibles;
a power source for applying a voltage to the heat wire;
and a contact pad (132a) on the plurality of crucibles for connecting the power source and the heat wire to each other.

12. The thin film deposition apparatus of claim 11, further comprising a ball bearing (140) between the contact pad (132a) and the power source.

13. The thin film deposition apparatus of claim 11,
wherein a plurality of contact pads (132a) are respectively disposed in the plurality of crucibles (110), and
wherein a plurality of power sources corresponding to the plurality of contact pads (132a) are respectively disposed so as to selectively apply the voltage.

## Patentansprüche

1. Dünnfilmablagerungsvorrichtung, aufweisend:
eine Bewegungseinheit (300), die konfiguriert ist, um ein Substrat (10) als ein Ablagerungsziel zu bewegen;
eine Maskeneinheit (200), die konfiguriert ist, selektiv Dampf einer Ablagerungsquelle zum Substrat (10) zu leiten, wobei die Maskeneinheit (200) ein Maskenelement (210), das einen Körper, in dem ein Maskenmuster (211) ausgebildet ist, eine Antriebsvorrichtung zum Bewegen des Maskenelements (210) aufweist, und
ein Leistungsübertragungselement (220), das konfiguriert ist, Leistung der Antriebsvorrichtung zum Maskenelement (210) zu übertragen; und
eine Schmelztiegeleinheit (100), die eine Umlaufschiene (120), die einen Umlaufweg, der durch die Maskeneinheit (200) verläuft, eine Vielzahl von Schmelztiegeln (110) zum Aufnehmen der Ablagerungsquelle, die auf der Umlaufschiene (120) angebracht sind, eine Sahmelztlegel-Bewegungseinheit (160), die konfiguriert ist, um die Vielzahl der Schmelztiegel (110) entlang der Umlaufschiene (120) zu bewegen, eine Schmelztiegel-Fülleinheit (150) zum Füllen der Ablagerungsquelle in der Vielzahl der Schmelztiegel (110), und eine Schmelztiegel-Erhitzungseinheit (130), die konfiguriert ist, um die Vielzahl der Schmelztiegel (110) zum Erzeugen von Dampf der Ablagerungsquelle zu erhitzen, aufweist.

2. Dünnfilmablagerungsvorrichtung nach Anspruch 1, wobei die Bewegungseinheit (300) aufweist:
eine Spannvorrichtung (310), die konfiguriert ist, das Substrat (10) zu tragen und
sich zusammen mit der Maskeneinheit (200) zu bewegen; und
eine Führungsschiene (320) zum Tragen der Spannvorrichtung (310), so dass diese entlang der Führungsschiene (320) gleitet.

3. Dünnfilmablagerungsvorrichtung nach Anspruch 1 oder 2, weiterhin aufweisend ein Abschirmelement (700) zum Leiten des Dampfes der Ablagerungsquelle zu einem Ablagerungsort des Substrats (10).

4. Dünnfilmablagerungsvorrichtung nach einem der vorhergehenden Ansprüche, weiterhin aufweisend eine Maskenreinigungseinheit (400) zum Entfernen eines Rückstands der Ablagerungsquelle, der an der Maskeneinheit (200) anhaftet

5. Dünnfilmablagerungsvorrichtung nach Anspruch 1, wobei der Körper des Maskenelements (210) zylindrisch ist.

6. Dünnfilmablagerungsvorrichtung nach Anspruch 5,
wobei das Leistungsübertragungselement (220) ein ringförmiges Element aufweist, das einen Hohlraum aufweist,
wobei das Maskenelement (210) in dem Hohlraum benachbart zu einer Innenwand (221) des ringförmigen Elements eingesetzt ist, und
wobei eine Getriebeeinheit (222) zum Übertragen von Leistung des Treibers auf einer Außenwand des ringförmigen Elements angeordnet ist.

7. Dünnfilmablagerungsvorrichtung nach Anspruch 1, weiterhin aufweisend eine Vielzahl von Kugellagern (140) zum Tragen der Vielzahl der Schmelztiegel auf der Umlaufschiene (120).

8. Dünnfilmablagerungsvorrichtung nach Anspruch 1, weiterhin aufweisend eine Feder (141) auf der Umlaufschiene (120), die konfiguriert ist, die Vielzahl der Schmelztiegel (110) zu einer Wand der Umlaufschiene (120) zu drücken.

9. Dünnfilmablagerungsvorrichtung nach Anspruch 1, wobei die Schmelztiegel-Bewegungseinheit (100) ein drehbares Bewegungsrad (161), das konfiguriert ist, um die Vielzahl der Schmelztiegel (110) in eine Richtung des Umlaufwegs zu drücken, aufweist.

10. Dünnfilmablagerungsvorrichtung nach Anspruch 1, wobei die Schmelztiegel-Fülleinheit (150) aufweist:
einen Einspritzbehälter, in dem die Ablagerungsquelle beschickt wird; und
eine Einspritzdüse zum Zuführen der im Einspritzbehälter beschickten Ablagerungsquelle zu der Vielzahl der Schmelztiegel auf der Umlaufschiene.

11. Dünnfilmablagerungsvorrichtong nach Anspruch 1, wobei die Schmelztiegel-Erhitzungseinheit (130) aufweist:
einen Heizdraht (131), der in der Vielzahl der Schmelztiegel eingebettet ist;
eine Energiequelle zum Anlegen einer Spannung an den Heizdraht;
und ein Kontaktpad (132a) auf der Vielzahl der Schmelztiegel zum Miteinander-Verbinden der Energiequelle und des Heizdrahts.

12. Dünnfilmablagerungsvorrichtung nach Anspruch 11, weiterhin aufweisend ein Kugellager (140) zwischen dem Kontaktpad (132a) und der Energiequelle.

13. Dünnfilmablagerungsvorrichtung nach Anspruch 11,
wobei eine Vielzahl von Kontaktpads (132a) jeweils in der Vielzahl der Schmelztiegel (110) angeordnet ist, und
wobei eine Vielzahl von Energiequellen entsprechend der Vielzahl der Kontaktpads (132a) jeweils so angeordnet sind, dass sie die Spannung selektiv anlegen.

## Revendications

1. Appareil de déposition de film mince, comprenant :
une unité de déplacement (300) configurée de façon à déplacer un substrat (10) constituant une cible de déposition ;
une unité de masque (200) configurée de façon à faire passer de façon sélective une vapeur d'une source de déposition vers le substrat (10), l'unité de masque (200) comprenant un élément de masque (210) comprenant un corps dans lequel est formé un motif de masque (211), un dispositif d'entraînement pour déplacer l'élément de masque (210), et
un élément de transfert d'énergie (220) configuré de façon à transférer de l'énergie du dispositif d'entraînement à l'élément de masque (210) ; et
une unité de creusets (100) comprenant un rail de circulation (120) formant un trajet de circulation traversant l'unité de masque (200), une pluralité de creusets (110) pour recevoir la source de déposition et installés sur le rail de circulation (120), une unité de déplacement de creusets (160) configurée de façon à déplacer la pluralité de creusets (110) le long du rail de circulation (120), une unité de remplissage de creusets (150) pour remplir par la source de déposition la pluralité de creusets (110), et une unité de chauffage de creusets (130) configurée de façon à chauffer la pluralité de creusets (110) afin de générer de la vapeur de la source de déposition.

2. Appareil de déposition de film mince selon la revendication 1, dans lequel l'unité de déplacement (300) comprend :
un dispositif de serrage (310) configuré de façon à supporter le substrat (10) et à se déplacer avec l'unité de masque (200) ; et
un rail de guidage (320) pour supporter le dispositif de serrage (310) de façon à coulisser le long du rail de guidage (320).

3. Appareil de déposition de film mince selon la revendication 1 ou 2, comprenant de plus un élément de blindage (700) pour guider la vapeur de la source de déposition vers un emplacement de déposition du substrat (10).

4. Appareil de déposition de film mince selon l'une quelconque des revendications précédentes, comprenant de plus une unité de lavage de masque (400) pour retirer un résidu de la source de déposition fixé à l'unité de masque (200).

5. Appareil de déposition de film mince selon la revendication 1, dans lequel le corps de l'élément de masque (210) est cylindrique.

6. Appareil de déposition de film mince selon la revendication 5,
dans lequel l'élément de transfert d'énergie (220) comprend un élément de forme annulaire comportant une cavité,
dans lequel l'élément de masque (210) est inséré dans la cavité au voisinage d'une paroi intérieure (221) de l'élément de forme annulaire, et
dans lequel une unité d'engrenage (222) pour transférer une énergie du dispositif d'entraînement est disposée sur une paroi extérieure de l'élément de forme annulaire.

7. Appareil de déposition de film mince selon la revendication 1, comprenant de plus une pluralité de roulements à billes (140) pour supporter la pluralité de creusets sur le rail de circulation (120).

8. Appareil de déposition de film mince selon la revendication 1, comprenant de plus un ressort (141) sur le rail de circulation (120) et configuré de façon à pousser la pluralité de creusets (110) vers une paroi du rail de circulation (120).

9. Appareil de déposition de film mince selon la revendication 1, dans lequel l'unité de déplacement de creusets (100) comprend une roue de déplacement rotative (161) configurée de façon à pousser la pluralité de creusets (110) dans une direction du trajet de circulation.

10. Appareil de déposition de film mince selon la revendication 1, dans lequel l'unité de remplissage de creusets (150) comprend :
un réservoir d'injection dans lequel est chargée la source de déposition ; et
une buse d'injection pour délivrer la source de déposition chargée dans le réservoir d'injection à la pluralité de creusets sur le rail de circulation.

11. Appareil de déposition de film mince selon la revendication 1, dans lequel l'unité de chauffage de creusets (130) comprend :
un fil de chauffage (131) incorporé dans la pluralité de creusets ;
une source d'alimentation pour appliquer une tension sur le fil de chauffage ;
et une zone de contact (132a) sur la pluralité de creusets pour connecter la source de chauffage et le fil chauffant l'un à l'autre.

12. Appareil de déposition de film mince selon la revendication 11, comprenant de plus un roulement à billes (140) entre la zone de contact (132a) et la source d'alimentation.

13. Appareil de déposition de film mince selon la revendication 11,
dans lequel une pluralité de zones de contact (132a) sont respectivement disposées dans la pluralité de creusets (110), et
dans lequel une pluralité de sources d'alimentation correspondant à la pluralité de zones de contact (132a) sont respectivement disposées de façon à appliquer la tension de façon sélective.
